(19) Europäisches Patentamt
European Patent Office
Office européen des brevets

(11) EP 2 927 269 A1

(12) # EUROPEAN PATENT APPLICATION
published in accordance with Art. 153(4) EPC

(43) Date of publication:
**07.10.2015 Bulletin 2015/41**

(21) Application number: **13857867.9**

(22) Date of filing: **06.08.2013**

(51) Int Cl.:
***C08J 9/04*** *(2006.01)* ***C08K 3/00*** *(2006.01)*
***C08L 101/00*** *(2006.01)*

(86) International application number:
**PCT/JP2013/071287**

(87) International publication number:
**WO 2014/083890 (05.06.2014 Gazette 2014/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **27.11.2012 JP 2012258401**
**28.03.2013 JP 2013070418**
**28.03.2013 JP 2013070420**
**28.03.2013 JP 2013070429**

(71) Applicant: **Sekisui Chemical Co., Ltd.**
**Osaka-shi, Osaka 530-8565 (JP)**

(72) Inventors:
- **KATO, Tetsuhiro**
  **Hasuda-shi**
  **Saitama 349-0198 (JP)**
- **SHIMONISHI, Koji**
  **Hasuda-shi**
  **Saitama 349-0198 (JP)**
- **KURINO, Yukinori**
  **Hasuda-shi**
  **Saitama 349-0198 (JP)**

(74) Representative: **Ter Meer Steinmeister & Partner**
**Patentanwälte mbB**
**Nymphenburger Straße 4**
**80335 München (DE)**

(54) **HEAT-CONDUCTING FOAM SHEET FOR ELECTRONIC INSTRUMENTS AND HEAT-CONDUCTING LAMINATE FOR ELECTRONIC INSTRUMENTS**

(57) Provided is a heat conductive foam sheet for electronic equipment sufficiently thin and flexible to be suitably used in the interior of electronic equipment and excellent in heat conductivity. A heat conductive foam sheet for electronic equipment containing a heat conductor in an elastomer resin portion constituting the foam sheet, in which the content of the heat conductor relative to 100 parts by mass of the elastomer resin is 100 to 500 parts by mass, the 25% compressive strength of the foam sheet is 200 kPa or less and the thickness thereof is 0.05 to 1 mm.

FIG. 1

Aluminum plate
Sample
Heater
Heat-insulating material

EP 2 927 269 A1

## Description

### Technical Field

The present invention relates to a heat conductive foam sheet for electronic equipment and a heat conductive laminate for electronic equipment for effectively dissipating interior heat of electronic equipment to the exterior.

### Background Art

In electronic equipment such as smartphones requiring a reduction in size, electronic parts are highly densely integrated and generate a large amount of heat. Since such heat causes a malfunction, a heat sink material is provided for dissipating the heat to the exterior of the equipment. As the heat sink material, which is generally provided between electronic parts serving as a heat generator and a metal case, e.g., heat dissipation grease and heat dissipation gel, which highly accurately follows a concavo-convex shape and urethane foam impregnated with each of these are used (for example, Patent Literature 1).

### Citation List

### Patent Literature

PTL1: Japanese Patent Laid-Open No. 2003-31980

### Summary of invention

### Technical Problem

The heat dissipation grease satisfactorily dissipates heat; however, it has a problem in that once it is applied, it is difficult to re-apply the grease, with the result that the production yield decreases. On the other hand, the heat dissipation gel has a problem in that it is generally difficult to process the gel into a sheet-like product having a thickness of 1 mm or less, and that, if compressed, the shape is deformed. In addition, the heat-dissipation gel has a problem in that if the thickness of the sheet reduces, compressive strength increases and flexibility decreases.

In contrast, it is difficult to mold a urethane foam into a sheet having a thickness of 1 mm or less for the reason of its process, and it is difficult to increase a ratio for a thin sheet-like product. Thus, the urethane foam has a problem in that the compressive strength increases and flexibility disappears.

The present invention was made in view of the above problems of conventional products and is directed to providing a heat conductive foam sheet for electronic equipment and a heat conductive laminate for electronic equipment sufficiently thin and flexible to be suitably used in the interior of electronic equipment and excellent in heat conductivity.

### Solution to Problem

The present invention mainly relates to the following [1] to [3].

[1] A heat conductive foam sheet for electronic equipment containing a heat conductor in an elastomer resin portion constituting the foam sheet, in which the content of the heat conductor relative to 100 parts by mass of the elastomer resin is 100 to 500 parts by mass, the 25% compressive strength of the foam sheet is 200 kPa or less and a thickness thereof is 0.05 to 1 mm.

[2] A heat conductive foam sheet for electronic equipment containing a heat conductor in an elastomer resin portion constituting the foam sheet, in which the heat conductor has a scale-like shape defined by a major axis of 1 to 300 μm, a minor axis of 1 to 300 μm and a ratio of the major axis to thickness (major axis/thickness) of 2 to 500 and/or a fibrous shape defined by a diameter of 0.01 to 50 μm and a ratio of length to the diameter (length/diameter) of 5 to 30,000; and the 25% compressive strength of the foam sheet is 200 kPa or less and the thickness thereof is 0.05 to 1 mm.

[3] A heat conductive laminate for electronic equipment, which has a heat conductive sheet having a heat conductivity of 200 W/m·K or more, on at least one of the surfaces of a foam sheet having a 25% compressive strength of 200 kPa or less and a thickness of 0.05 to 1.0 mm; and which has a thickness of 0.08 to 1.50 mm.

Advantageous Effects of Invention

According to the present invention, it is possible to provide a heat conductive foam sheet for electronic equipment and a heat conductive laminate for electronic equipment sufficiently thin and flexible to be suitably used in the interior of electronic equipment and excellent in heat conductivity.

Brief Description of Drawings

[Fig. 1] Fig. 1 is a view showing an apparatus for evaluating heat dissipation performance of a foam sheet produced in each of Examples and Comparative Examples.
[Fig. 2] Fig. 2 is a view showing an apparatus for evaluating heat dissipation performance of a foam sheet and a laminate produced in each of Examples and Comparative Examples.

Description of Embodiments

[Heat conductive foam sheet (1) for electronic equipment of the present invention]

The heat conductive foam sheet (1) for electronic equipment of the present invention refers to a heat conductive foam sheet for electronic equipment containing a heat conductor in an elastomer resin portion constituting the foam sheet, in which the content of the heat conductor relative to 100 parts by mass of the elastomer resin is 100 to 500 parts by mass, the 25% compressive strength of the foam sheet is 200 kPa or less and the thickness thereof is 0.05 to 1 mm.

<Foam sheet>

In the heat conductive foam sheet (1) for electronic equipment, the 25% compressive strength of the foam sheet is 200 kPa or less. It is not preferable that the compressive strength exceeds 200 kPa, because, if so, the flexibility of the foam sheet decreases. In view of the flexibility of the foam sheet, the 25% compressive strength of the foam sheet is preferably 5 kPa or more, more preferably 50 kPa or more and further preferably 55 kPa or more; and preferably 190 kPa or less, more preferably 180 kPa or less, further preferably 150 kPa or less and further more preferably 100 kPa or less.
As a specific numerical value, the 25% compressive strength of the foam sheet is preferably 5 to 190 kPa, more preferably 50 to 190 kPa, more preferably 50 to 150 kPa and further preferably 55 to 100 kPa.
The foam sheet to be used in the heat conductive foam sheet (1) for electronic equipment is preferably constituted of an elastomer resin containing a liquid elastomer in an amount of 10 mass% or more. The 50% compressive strength of the foam sheet is preferably 200 kPa or less. If the 50% compressive strength of the foam sheet is 200 kPa or less, the foam sheet can be suitably used in thin electronic equipment such as mobile terminals.
In view of flexibility improvement, the 50% compressive strength of the foam sheet is more preferably 150 kPa or less and further preferably 100 kPa or less.
The content of the liquid elastomer in the elastomer resin is preferably 10 mass% or more and more preferably 20 mass% or more; and preferably 90 mass% or less and more preferably 80 mass% or less.
The thickness of the foam sheet is 0.05 to 1 mm. If the thickness of the foam sheet is less than 0.05 mm, the foam sheet is easily torn; whereas, if the thickness exceeds 1 mm, it is difficult to use the foam sheet in the interior space of small electronic equipment. In view of the strength of the foam sheet, the thickness of the foam sheet is preferably 0.05 to 0.8 mm, more preferably 0.05 to 0.7 mm and further preferably 0.05 to 0.5 mm.
The dielectric constant of the foam sheet is preferably 4 or less. It is not preferable that the dielectric constant of the foam sheet exceeds 4, because, if so, malfunction of electronic equipment is sometimes caused. The dielectric constant of the foam sheet is preferably 1 to 3 and more preferably 1 to 2.
The heat conductivity of the foam sheet is preferably 0.3 to 10 W/m·K and more preferably 0.4 to 2.0 W/m·K. If the heat conductivity of the foam sheet falls within the above range, it is possible to effectively dissipate interior heat of electronic equipment to the exterior.
The expansion ratio of the foam sheet is preferably 1.5 to 5, more preferably 1.5 to 3 and further preferably 1.5 to 2.5. If the expansion ratio of the foam sheet falls within the above range, it is possible for the foam sheet to be not only thin but also flexible.
The apparent density of the foam sheet is preferably 0.4 g/cm$^3$ or more, more preferably 0.5 g/cm$^3$ or more, more preferably 0.6 g/cm$^3$ or more, further preferably 0.7 g/cm$^3$ or more and further more preferably 0.85 g/cm$^3$ or more; and preferably 1.5 g/cm$^3$ or less, more preferably 1.4 g/cm$^3$ or less and further preferably 1.2 g/cm$^3$ or less.
As a more specific numerical value, the apparent density of the foam sheet is preferably 0.4 to 1.5 g/cm$^3$, more

preferably 0.4 to 1.4 g/cm$^3$, further preferably 0.7 to 1.4 g/cm$^3$ and further more preferably 0.85 to 1.2 g/cm$^3$. If the apparent density of the foam sheet falls within the above range, it is possible for the foam sheet to obtain a desired thickness in combination with flexibility and heat conductivity.

<Elastomer resin>

Examples of the elastomer resin that can be used in the heat conductive foam sheet (1) for electronic equipment include an acrylonitrile butadiene rubber, a liquid-state acrylonitrile butadiene rubber, an ethylene-propylene-diene rubber, a liquid-state ethylene-propylene-diene rubber, an ethylene-propylene rubber, a liquid-state ethylene-propylene rubber, a natural rubber, a liquid-state natural rubber, a polybutadiene rubber, a liquid-state polybutadiene rubber, a polyisoprene rubber, a liquid-state polyisoprene rubber, a styrene-butadiene block copolymer, a liquid-state styrene-butadiene block copolymer, a hydrogenated styrene-butadiene block copolymer, a liquid-state hydrogenated styrene-butadiene block copolymer, a hydrogenated styrene-butadiene-styrene block copolymer, a liquid-state hydrogenated styrene-butadiene-styrene block copolymer, a hydrogenated styrene-isoprene block copolymer, a liquid-state hydrogenated styrene-isoprene block copolymer, a hydrogenated styrene-isoprene-styrene block copolymer and a liquid-state hydrogenated styrene-isoprene-styrene block copolymer. Of these, an acrylonitrile butadiene rubber, a liquid-state acrylonitrile butadiene rubber, an ethylene-propylene-diene rubber, a liquid-state ethylene-propylene-diene rubber and a butyl rubber (isobutylene-isoprene rubber) are preferable.

<Heat conductor>

Examples of the heat conductor that can be used in the heat conductive foam sheet (1) for electronic equipment include aluminum oxide, magnesium oxide, boron nitride, talc, aluminum nitride, graphite and graphene. Of these, aluminum oxide and magnesium oxide are preferable. These heat conductors may be used alone or as a mixture of two or more.

The heat conductivity of the heat conductor is preferably 5 W/m·K or more, and more preferably 20 W/m·K or more. If the heat conductivity falls within the above range, the heat conductivity of the resultant foam sheet will be sufficiently high.

The content of the heat conductor relative to 100 parts by mass of the elastomer resin is 100 to 500 parts by mass. If the content of the heat conductor is less than 100 parts by mass, it is impossible for the foam sheet to obtain sufficient heat conductivity; whereas, if the content of the heat conductor exceeds 500 parts by mass, the flexibility of the foam sheet decreases. In view of heat conductivity and flexibility of the foam sheet, the content of the heat conductor relative to 100 parts by mass of the elastomer resin is preferably 120 to 480 parts by mass, more preferably 120 to 400 parts by mass, further preferably 150 to 450 parts by mass and further more preferably 150 to 350 parts by mass.

<Optional components>

In the heat conductive foam sheet (1) for electronic equipment, if necessary, various types of additional components can be contained within the range where the objects of the present invention will not be damaged.

The types of additional components are not particularly limited and various additives that are usually used in expansion molding can be used. Examples of such additives include a lubricant, a shrinkage inhibitor, a foam nucleating agent, a nucleating agent for crystallization, a plasticizer, a coloring agent (e.g., pigment, dye), a UV absorbent, an antioxidant, an anti-aging agent, a filler excluding the aforementioned conductivity imparting material, a strengthening agent, a flame retardant, a flame retardant promoter, an antistatic agent, a surfactant, a vulcanizing agent and a surface treatment agent. The addition amounts of additives can be appropriately selected as long as formation of air foam is not damaged. The addition amounts of additives that are usually used for expansion and molding of a resin can be employed. These additives can be used alone or in combination of two or more.

The lubricant not only improves flowability of a resin but also suppresses deterioration of a resin by heat. The lubricant to be used in the present invention is not particularly limited as long as it effectively improves flowability of a resin. Example thereof include hydrocarbon lubricants such as liquid paraffin, paraffin wax, microwax and polyethylene wax; fatty acid lubricants such as stearic acid, behenic acid and 12-hydroxy stearic acid; and ester lubricants such as butyl stearate, stearic acid monoglyceride, pentaerythritol tetrastearate, hydrogenated castor oil and stearyl stearate.

The addition amount of the lubricant relative to 100 parts by mass of a resin is preferably about 0.01 to 5 parts by mass, more preferably 0.05 to 4 parts by mass and further preferably 0.1 to 3 parts by mass. If the addition amount exceeds 10 parts by mass, flowability becomes extremely high, with the result that the expansion ratio may decrease. In contrast, if the addition amount is less than 0.01 parts by mass, flowability cannot be improved and stretchability during foam formation decreases, with the result that the expansion ratio may decrease.

Examples of the flame retardant include, other than metal hydroxides such as aluminum hydroxide and magnesium hydroxide, bromine-based flame retardants such as decabromodiphenyl ether and phosphorus-based flame retardants such as ammonium polyphosphate.

Examples of the flame retardant promoter include antimony compounds such as antimony trioxide, antimony tetraoxide, antimony pentoxide, sodium pyroantimonate, antimony trichloride, antimony trisulfide, antimony oxychloride, antimony dichloride perchloropentane and potassium antimonate; boron compounds such as zinc metaborate, zinc tetraborate, zinc borate and basic zinc borate; zirconium oxides; tin oxides; and molybdenum oxides.

<Method for producing foam sheet>

The heat conductive foam sheet (1) for electronic equipment of the present invention can be produced by a chemical foaming method or a physical foaming method known in the art. The method for producing the sheet is not particularly limited.

Note that, as a foam-processing method, methods known in the art including those described in Plastic Foam Handbook (edited by Hiroshi Maki and Atsushi Osakada, published by NIKKAN KOGYO SHIMBUN, LTD., 1973) can be used.

[Heat conductive foam sheet (2) for electronic equipment of the present invention]

The heat conductive foam sheet (2) for electronic equipment of the present invention refers to a heat conductive foam sheet for electronic equipment containing a heat conductor in an elastomer resin portion constituting the foam sheet, in which the heat conductor has a scale-like shape defined by a major axis of 1 to 300 $\mu$m, a minor axis of 1 to 300 $\mu$m, a ratio of the major axis to thickness (major axis/thickness) of 2 to 500 and/or a fibrous shape defined by a diameter of 0.01 to 50 $\mu$m, a ratio of length to diameter (length/diameter) of 5 to 30,000, the 25% compressive strength of the foam sheet is 200 kPa or less and the thickness thereof is 0.05 to 1 mm.

<Foam sheet>

In the heat conductive foam sheet (2) for electronic equipment, the 25% compressive strength of the foam sheet to be used herein is 200 kPa or less. It is not preferable that the compressive strength exceeds 200 kPa, because, if so, the flexibility of the foam sheet decreases. In view of the flexibility of the foam sheet, the 25% compressive strength of the foam sheet is preferably 5 kPa or more, more preferably 50 kPa or more and further preferably 55 kPa or more; and preferably 190 kPa or less, more preferably 180 kPa or less, further preferably 150 kPa or less and further more preferably 100 kPa or less.

As a specific numerical value, the 25% compressive strength of the foam sheet is preferably 5 to 190 kPa, more preferably 50 to 190 kPa, further preferably 50 to 150 kPa and further more preferably 55 to 100 kPa.

The foam sheet to be used in the heat conductive foam sheet (2) for electronic equipment is preferably constituted of an elastomer resin containing a liquid elastomer in an amount of 10 mass% or more. The 50% compressive strength of the foam sheet is preferably 200 kPa or less. If the 50% compressive strength of the foam sheet is 200 kPa or less, the foam sheet can be suitably used in thin electronic equipment such as mobile terminals.

In view of flexibility improvement, the 50% compressive strength of the foam sheet is more preferably 150 kPa or less and further preferably 100 kPa or less.

The content of the liquid elastomer in the elastomer resin is preferably 10 mass% or more and more preferably 20 mass% or more; and preferably 90 mass% or less and more preferably 80 mass% or less.

The thickness of the foam sheet is 0.05 to 1 mm. If the thickness of the foam sheet is less than 0.05 mm, the foam sheet is easily torn; whereas, if the thickness exceeds 1 mm, it is difficult to use the foam sheet in the interior space of small electronic equipment. In view of the strength of the foam-sheet, the thickness of the foam sheet is preferably 0.05 to 0.8 mm, more preferably 0.05 to 0.7 mm and further preferably 0.05 to 0.5 mm.

The heat conductivity of the foam sheet is preferably 0.3 to 10 W/m·K and more preferably 0.4 to 2 W/m·K. If the heat conductivity of the foam sheet falls within the above range, it is possible to effectively dissipate interior heat of electronic equipment to the exterior.

The expansion ratio of the foam sheet is preferably 1.5 to 5, more preferably 1.5 to 3 and further preferably 1.5 to 2.5. If the expansion ratio of the foam sheet falls within the above range, it is possible to obtain a foam sheet not only thin but also flexible.

The apparent density of the foam sheet is preferably 0.4 g/cm$^3$ or more, more preferably 0.5 g/cm$^3$ or more, more preferably 0.6 g/cm$^3$ or more, further preferably 0.7 g/cm$^3$ or more and further more preferably 0.85 g/cm$^3$ or more; and preferably 1.5 g/cm$^3$ or less, more preferably 1.4 g/cm$^3$ or less and further preferably 1.2 g/cm$^3$ or less.

As a specific numerical value, the apparent density of the foam sheet is preferably 0.4 to 1.5 g/cm$^3$, more preferably 0.4 to 1.4 g/cm$^3$, further preferably 0.7 to 1.4 g/cm$^3$, and further more preferably 0.85 to 1.2 g/cm$^3$. If the

apparent density of the foam sheet falls within the above range, it is possible to obtain a foam sheet having a desired thickness in combination with flexibility and heat conductivity.

<Heat conductor>

In the heat conductive foam sheet (2) for electronic equipment, a heat conductor, which has a scale-like shape defined by a major axis of 1 to 300 μm, a minor axis of 1 to 300 μm, a ratio of the major axis to thickness (major axis/thickness) of 2 to 500 and/or a fibrous shape defined by a diameter of 0.01 to 50 μm, a ratio of length to the diameter (length/diameter) of 5 to 30,000, is used. If the shape is defined by numerical values outside the above range, it is impossible to highly densely pack the foam sheet with the heat conductor, with the result that the heat conductivity of the foam sheet decreases.

In the case where the heat conductor has a scale-like shape, the major axis is preferably 1 to 250 μm, more preferably 2 to 200 μm and further preferably 2 to 50 μm. The minor axis is preferably 1 to 250 μm, more preferably 2 to 200 μm and further preferably 2 to 50 μm. The ratio of major axis to thickness (major axis/thickness) is preferably 2.5 to 450 and more preferably 3 to 400.

In the case where the heat conductor has a fibrous shape, the diameter is more preferably 0.05 to 45 μm and further preferably 0.07 to 40 μm. The ratio of length to diameter (length/diameter) is more preferably 6 to 28,000 and further preferably 7 to 26,000.

Examples of the heat conductor include boron nitride, talc, aluminum nitride, a carbon nanotube, a carbon fiber, aluminum oxide, magnesium oxide, graphite and graphene. Of these, boron nitride, talc, aluminum nitride, graphite, a carbon nanotube and a carbon fiber are preferable. These heat conductors may be used alone or as a mixture of two or more.

The heat conductivity of the heat conductor is preferably 30 W/m·K or more and more preferably 40 W/m·K or more. If the heat conductivity falls within the above range, the heat conductivity of the resultant foam sheet will be sufficiently high.

The content of the heat conductor relative to 100 parts by mass of the elastomer resin is preferably 100 to 500 parts by mass, preferably 120 to 400 parts by mass and more preferably 150 to 350 parts by mass. If the content of the heat conductor falls within the above range, it is possible for the foam sheet to obtain sufficient heat conductivity while suppressing reduction of flexibility.

<Elastomer resin>

Examples of the elastomer resin that can be used in the heat conductive foam sheet (2) for electronic equipment include an acrylonitrile butadiene rubber, a liquid-state acrylonitrile butadiene rubber, an ethylene-propylene-diene rubber, a liquid-state ethylene-propylene-diene rubber, an ethylene-propylene rubber, a liquid-state ethylene-propylene rubber, a natural rubber, a liquid-state natural rubber, a polybutadiene rubber, a liquid-state polybutadiene rubber, a polyisoprene rubber, a liquid-state polyisoprene rubber, a styrene-butadiene block copolymer, a liquid-state styrene-butadiene block copolymer, a hydrogenated styrene-butadiene block copolymer, a liquid-state hydrogenated styrene-butadiene block copolymer, a hydrogenated styrene-butadiene-styrene block copolymer, a liquid-state hydrogenated styrene-butadiene-styrene block copolymer, a hydrogenated styrene-isoprene block copolymer, a liquid-state hydrogenated styrene-isoprene block copolymer, a hydrogenated styrene-isoprene-styrene block copolymer and a liquid-state hydrogenated styrene-isoprene-styrene block copolymer. Of these, an acrylonitrile butadiene rubber, a liquid-state acrylonitrile butadiene rubber, an ethylene-propylene-diene rubber and a liquid-state ethylene-propylene-diene rubber are preferable.

<Optional components>

In the heat conductive foam sheet (2) for electronic equipment, if necessary, various types of additional components can be contained within the range where the objects of the present invention will not be damaged.

The types of additional components are not particularly limited and various additives that are usually used in expansion molding can be used. Examples of such additives include a lubricant, a shrinkage inhibitor, a foam nucleating agent, a nucleating agent for crystallization, a plasticizer, a coloring agent (e.g., pigment, dye), a UV absorbent, an antioxidant, an anti-aging agent, a filler excluding the aforementioned conductivity imparting material, a strengthening agent, a flame retardant, a flame retardant promoter, an antistatic agent, a surfactant, a vulcanizing agent and a surface treatment agent. The addition amounts of additives can be appropriately selected as long as formation of air foam is not damaged. The addition amounts of additives that are usually used for expansion molding of a resin can be employed. These additives can be used alone or in combination of two or more.

The lubricant not only improves flowability of a resin but also suppresses deterioration of a resin by heat. The lubricant to be used in the present invention is not particularly limited as long as it effectively improves flowability of a resin. Example thereof include hydrocarbon lubricants such as liquid paraffin, paraffin wax, microwax and polyethylene wax; fatty acid lubricants such as stearic acid, behenic acid and 12-hydroxy stearic acid; and ester lubricants such as butyl stearate, stearic acid monoglyceride, pentaerythritol tetrastearate, hydrogenated castor oil and stearyl stearate.

The addition amount of lubricant relative to 100 parts by mass of a resin is preferably about 0.01 to 5 parts by mass, more preferably 0.05 to 4 parts by mass and further preferably 0.1 to 3 parts by mass. If the addition amount exceeds 5 parts by mass, flowability becomes extremely high, with the result that the expansion ratio may decrease. In contrast, if the addition amount is less than 0.01 parts by mass, flowability cannot be improved and stretchability during foam formation decreases, with the result that the expansion ratio may decrease.

Examples of the flame retardant include, other than metal hydroxides such as aluminum hydroxide and magnesium hydroxide, bromine-based flame retardants such as decabromodiphenyl ether and phosphorus-based flame retardants such as ammonium polyphosphate.

Examples of the flame retardant promoter include antimony compounds such as antimony trioxide, antimony tetroxide, antimony pentoxide, sodium pyroantimonate, antimony trichloride, antimony trisulfide, antimony oxychloride, antimony dichloride perchloropentane and potassium antimonate; boron compounds such as zinc metaborate, zinc tetraborate, zinc borate and basic zinc borate; zirconium oxides; tin oxides; and molybdenum oxides.

<Method for producing foam sheet>

The heat conductive foam sheet (2) for electronic equipment of the present invention can be produced by a chemical foaming method or a physical foaming method known in the art. The method for producing the sheet is not particularly limited.

Note that, as a foam-processing method, methods known in the art including those described in Plastic Foam Handbook (edited by Hiroshi Maki and Atsushi Osakada, published by NIKKAN KOGYO SHIMBUN, LTD., 1973) can be used.

[Heat conductive laminate for electronic equipment of the present invention]

The heat conductive laminate for electronic equipment of the present invention refers to a laminate having a heat conductive sheet, which has a heat conductivity of 200 W/m·K or more, on at least one of the surfaces of a foam sheet having a 25% compressive strength of 200 kPa or less and a thickness of 0.05 to 1.0 mm; and having a thickness of 0.08 to 1.50 mm.

<Foam sheet>

In the heat conductive laminate for electronic equipment of the present invention, the 25% compressive strength of the foam sheet used herein is 200 kPa or less. It is not preferable that the compressive strength exceeds 200 kPa, because, if so, the flexibility of the foam sheet decreases. In view of the flexibility of the foam sheet, the 25% compressive strength of the foam sheet is preferably 5 kPa or more, more preferably 50 kPa or more and further preferably 55 kPa or more; and preferably 190 kPa or less, more preferably 180 kPa or less, further preferably 150 kPa or less and further more preferably 100 kPa or less.

As a specific numerical value, the 25% compressive strength of the foam sheet is preferably 5 to 190 kPa, more preferably 50 to 190 kPa, further preferably 50 to 150 kPa and further more preferably 55 to 100 kPa.

The foam sheet to be used in the heat conductive laminate for electronic equipment of the present invention is preferably constituted of an elastomer resin containing a liquid elastomer in an amount of 10 mass% or more. The 50% compressive strength of the foam sheet is preferably 200 kPa or less. If the 50% compressive strength of the foam sheet is 200 kPa or less, the foam sheet can be suitably used in thin electronic equipment such as mobile terminals.

In view of flexibility improvement, the 50% compressive strength of the foam sheet is more preferably 150 kPa or less and further preferably 100 kPa or less.

The content of the liquid elastomer in the elastomer resin is preferably 10 mass% or more and more preferably 20 mass% or more; and preferably 90 mass% or less and more preferably 80 mass% or less.

The thickness of the foam sheet is 0.05 to 1 mm. If the thickness of the foam sheet is less than 0.05 mm, the foam sheet is easily torn; whereas, if the thickness exceeds 1 mm, it is difficult to use the foam sheet in the interior space of small electronic equipment. In view of the strength of the foam-sheet, the thickness of the foam sheet is preferably 0.05 to 0.8 mm, more preferably 0.05 to 0.7 mm and further preferably 0.05 to 0.5 mm.

The heat conductivity of the foam sheet is preferably 0.01 to 10 W/m·K and more preferably 0.05 to 2 W/m·K. If the heat conductivity of the foam sheet falls within the above range, it is possible to effectively dissipate interior heat of electronic equipment to the exterior.

The expansion ratio of the foam sheet is preferably 1.5 to 6, more preferably 1.5 to 5.5. If the expansion ratio of the foam sheet falls within the above range, it is possible for the foam sheet to be not only thin but also flexible.
The apparent density of the foam sheet is preferably about 0.1 to 1.5 g/cm$^3$, and preferably about 0.15 to 1.2 g/cm$^3$.

<Heat conductive sheet>

The heat conductive laminate for electronic equipment of the present invention has a heat conductive sheet having a heat conductivity of 200 W/m·K or more, on at least one of the surfaces of a foam sheet. Owing to the heat conductive sheet provided, it is possible to further effectively dissipate interior heat of electronic equipment to the exterior. In order to effectively dissipate heat to the exterior, the heat conductivity of the heat conductive sheet is preferably 300 to 3,000 W/m·K and more preferably 300 to 2,000 W/m·K.
The heat conductive sheet is not particularly limited as long as the heat conductivity of the sheet satisfies the aforementioned heat conductivity range. Specifically, e.g., copper, aluminum, gold, silver, iron, graphite and graphene are preferable.
The heat conductive sheet preferably has a thickness of 3 to 500 μm and more preferably 20 to 170 μm, in order to use the sheet in the interior of precision equipment.

<Laminate>

The thickness of the laminate of the present invention is 0.08 to 1.50 mm. If the thickness of the laminate is less than 0.08 mm, the laminate is easily torn; whereas, if the thickness exceeds 1.50 mm, it is difficult to use the laminate in the interior space of small electronic equipment. The thickness of the laminate is preferably 0.1 to 1.25 mm and more preferably 0.2 to 0.95 mm.

<Elastomer resin>

Examples of the elastomer resin that can be used in the heat conductive laminate for electronic equipment of the present invention include an acrylonitrile butadiene rubber, a liquid-state acrylonitrile butadiene rubber, a linear low-density polyethylene, an ethylene-propylene-diene rubber, a liquid-state ethylene-propylene-diene rubber, an ethylene-propylene rubber, a liquid-state ethylene-propylene rubber, a natural rubber, a liquid-state natural rubber, a polybutadiene rubber, a liquid-state polybutadiene rubber, a polyisoprene rubber, a liquid-state polyisoprene rubber, a styrene-butadiene block copolymer, a liquid-state styrene-butadiene block copolymer, a hydrogenated styrene-butadiene block copolymer, a liquid-state hydrogenated styrene-butadiene block copolymer, a hydrogenated styrene-butadiene-styrene block copolymer, a liquid-state hydrogenated styrene-butadiene-styrene block copolymer, a hydrogenated styrene-isoprene block copolymer, a liquid-state hydrogenated styrene-isoprene block copolymer, a hydrogenated styrene-isoprene-styrene block copolymer and a liquid-state hydrogenated styrene-isoprene-styrene block copolymer. Of these, an acrylonitrile butadiene rubber, a liquid-state acrylonitrile butadiene rubber, an ethylene-propylene-diene rubber, a liquid-state ethylene-propylene-diene rubber and a linear low-density polyethylene are preferable.

<Heat conductive filler>

In the heat conductive laminate for electronic equipment of the present invention, a heat conductive filler may be contained in the elastomer resin. Examples of the heat conductive filler include aluminum oxide, magnesium oxide, boron nitride, talc, aluminum nitride, graphite and graphene. Of these, aluminum oxide and magnesium oxide are preferable. These heat conductive fillers may be used alone or as a mixture of two or more.
The heat conductivity of the heat conductive filler is preferably 5 W/m·K or more and more preferably 20 W/m·K or more. If the heat conductivity falls within the above range, the heat conductivity of the resultant foam sheet will be sufficiently high.
The content of the heat conductive filler relative to 100 parts by mass of the elastomer resin is preferably 100 to 500 parts by mass, preferably 120 to 480 parts by mass and more preferably 150 to 450 parts by mass. If the content of the heat conductive filler falls within the above range, it is possible to obtain sufficient heat conductivity without reducing the flexibility of the foam sheet.

<Optional component>

In the heat conductive laminate for electronic equipment of the present invention, if necessary, various types of additional components can be contained within the range where the objects of the present invention will not be damaged.

The types of additional components are not particularly limited and various additives that are usually used in expansion molding can be used. Examples of such additives include a lubricant, a shrinkage inhibitor, a foam nucleating agent, a nucleating agent for crystallization, a plasticizer, a coloring agent (e.g., pigment, dye), a UV absorbent, an antioxidant, an anti-aging agent, a filler excluding the aforementioned conductivity imparting material, a strengthening agent, a flame retardant, a flame retardant promoter, an antistatic agent, a surfactant, a vulcanizing agent and a surface treatment agent. The addition amounts of additives can be appropriately selected as long as formation of air foam is not damaged. The addition amounts of additives that are usually used for expansion and molding of a resin can be employed. These additives can be used alone or in combination of two or more.

The lubricant not only improves flowability of a resin but also suppresses deterioration of a resin by heat. The lubricant to be used in the present invention is not particularly limited as long as it effectively improves flowability of a resin. Example thereof include hydrocarbon lubricants such as liquid paraffin, paraffin wax, microwax and polyethylene wax; fatty acid lubricants such as stearic acid, behenic acid and 12-hydroxy stearic acid; and ester lubricants such as butyl stearate, stearic acid monoglyceride, pentaerythritol tetrastearate, hydrogenated castor oil and stearyl stearate.

The addition amount of lubricant relative to 100 parts by mass of a resin is preferably about 0.01 to 5 parts by mass, more preferably 0.05 to 3 parts by mass and further preferably 0.1 to 3 parts by mass. If the addition amount exceeds 5 parts by mass, flowability becomes extremely high, with the result that the expansion ratio may decrease. In contrast, if the addition amount is less than 0.01 parts by mass, flowability cannot be improved and stretchability during foam formation decreases, with the result that the expansion ratio may decrease.

Examples of the flame retardant include, other than metal hydroxides such as aluminum hydroxide and magnesium hydroxide, bromine-based flame retardants such as decabromodiphenyl ether and phosphorus-based flame retardants such as ammonium polyphosphate.

Examples of the flame retardant promoter include antimony compounds such as antimony trioxide, antimony tetraoxide, antimony pentoxide, sodium pyroantimonate, antimony trichloride, antimony trisulfide, antimony oxychloride, antimony dichloride perchloropentane and potassium antimonate; boron compounds such as zinc metaborate, zinc tetraborate, zinc borate and basic zinc borate; zirconium oxides; tin oxides; and molybdenum oxides.

<Method for producing foam sheet>

The heat conductive laminate for electronic equipment of the present invention can be produced by a chemical foaming method or a physical foaming method known in the art. The production method is not particularly limited.

Note that, as a foam-processing method, methods known in the art including those described in Plastic Foam Handbook (edited by Hiroshi Maki and Atsushi Osakada, published by NIKKAN KOGYO SHIMBUN, LTD., 1973) can be used.

Examples

The present invention will be more specifically described by way of Examples; however, the present invention is not limited by these Examples.

[Heat conductive foam sheet (1) for electronic equipment of the present invention]

The materials used in the following Examples and Comparative Examples regarding the heat conductive foam sheet (1) for electronic equipment of the present invention are as follows.

(1) Acrylonitrile butadiene rubber (NBR)
Trade name "Nipol 1041", manufactured by ZEON CORPORATION Density: 1.00 g/cm$^3$
Acrylonitrile component: 40.5 mass%
(2) liquid-state acrylonitrile butadiene rubber (liquid-state NBR)
Trade name "Nipol 1312", manufactured by ZEON CORPORATION, Density: 0.98 g/cm$^3$
(3) Ethylene-propylene-diene rubber (EPDM)
Trade name "EP21", manufactured by JSR Corporation,
Density: 0.86 g/cm$^3$
Content of propylene: 34 mass%
(4) Liquid ethylene-propylene-diene rubber (liquid-state EPDM)
Trade name "PX-068", manufactured by Mitsui Chemicals, Inc.
Density: 0.9 g/cm$^3$
Content of propylene: 39 mass%
(5) Azodicarbonamide

Trade name "SO-L", manufactured by Otsuka Chemical Co., Ltd.
(6) Aluminum oxide
Trade name "AX3-32", manufactured by Micron Inc.
Spherical alumina, average particle size: 3 μm
(7) Magnesium oxide
Trade name "RF-10C-SC", manufactured by Ube Material Industries Pulverized product, 45 μm or less, sieved average particle size: 4 μm
(8) Phenol oxidant
Trade name "IRGANOX1010", manufactured by Ciba Specialties Chemicals

<Examples 1 to 6 and Comparative Examples 1 to 3>

Example 1

100 parts by mass of an acrylonitrile butadiene rubber, 15 parts by mass of azodicarbonamide, 400 parts by mass of aluminum oxide and 0.1 parts by mass of a phenolic antioxidant were melt-kneaded and then pressed to obtain an expandable resin sheet having a thickness of 0.4 mm.

To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.98 g/cm$^3$ and a thickness of 0.5 mm.

Example 2

80 parts by mass of an acrylonitrile butadiene rubber, 20 parts by mass of a liquid-state acrylonitrile butadiene rubber, 17 parts by mass of azodicarbonamide, 400 parts by mass of aluminum oxide and 0.1 parts by mass of a phenol oxidant were melt-kneaded and then pressed to obtain an expandable resin sheet having a thickness of 0.4 mm.

To both surfaces of the obtained expandable resin sheet, 1.4 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 1.00 g/cm$^3$ and a thickness of 0.5 mm.

Example 3

70 parts by mass of an ethylene-propylene-diene rubber, 30 parts by mass of a liquid-state ethylene-propylene-diene rubber, 17 parts by mass of azodicarbonamide, 400 parts by mass of aluminum oxide and 0.1 parts by mass of a phenol oxidant were melt-kneaded and then pressed to obtain an expandable resin sheet having a thickness of 0.4 mm.

To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.70 g/cm$^3$ and a thickness of 0.5 mm.

Example 4

100 parts by mass of an ethylene-propylene-diene rubber, 17 parts by mass of azodicarbonamide, 400 parts by mass of aluminum oxide and 0.1 parts by mass of a phenol oxidant were melt-kneaded and then pressed to obtain an expandable resin sheet having a thickness of 0.43 mm.

To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.95 g/cm$^3$ and a thickness of 0.5 mm.

Example 5

100 parts by mass of an ethylene-propylene-diene rubber, 17 parts by mass of azodicarbonamide, 360 parts by mass of magnesium oxide and 0.1 parts by mass of a phenol oxidant were melt-kneaded and then pressed to obtain an expandable resin sheet having a thickness of 0.43 mm.

To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.98 g/cm$^3$ and a thickness of 0.5 mm.

Example 6

60 parts by mass of an ethylene-propylene-diene rubber, 40 parts by mass of a liquid-state ethylene-propylene-diene rubber, 17 parts by mass of azodicarbonamide, 360 parts by mass of magnesium oxide and 0.1 parts by mass of a phenol oxidant were melt-kneaded and then pressed to obtain an expandable resin sheet having a thickness of 0.4 mm.

To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.60 g/cm$^3$ and a thickness of 0.5 mm.

Comparative Example 1

100 parts by mass of an acrylonitrile butadiene rubber, 6 parts by mass of azodicarbonamide and 0.1 parts by mass were supplied to an extruder, melt-kneaded and then pressed to obtain an expandable resin sheet having a thickness of 0.25 mm.

To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.12 g/cm$^3$ and a thickness of 0.5 mm.

Comparative Example 2

100 parts by mass of an acrylonitrile butadiene rubber, 15 parts by mass of azodicarbonamide, 400 parts by mass of aluminum oxide and 0.1 parts by mass of a phenol oxidant were supplied to an extrusion kneader, melt-kneaded and then pressed to obtain an expandable resin sheet having a thickness of 1.6 mm.

To both surfaces of the obtained expandable resin sheet, 1.2 Mrad of an electron beam was applied at an acceleration voltage of 1000 keV to crosslink the expandable resin sheet. Subsequently, the sheet was heated to 250°C to expand the expandable resin sheet to obtain a foam sheet having an apparent density of 0.99 g/cm$^3$ and a thickness of 2.0 mm.

Comparative Example 3

100 parts by mass of an acrylonitrile butadiene rubber, 8 parts by mass of azodicarbonamide, 400 parts by mass of aluminum oxide and 0.1 parts by mass of a phenol oxidant were melt-kneaded and then pressed to obtain an expandable resin sheet having a thickness of 0.48 mm.

To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 1.93 g/cm$^3$ and a thickness of 0.5 mm.

<Physical properties>

Physical properties of the obtained foam sheets were measured as follows. The measurement results of individual properties are shown in Table 1.

[Expansion ratio]

The expansion ratio was calculated by dividing the specific gravity of a foam sheet by the specific gravity of an expandable resin sheet.

[Apparent density]

Apparent density was measured in accordance with JIS K 7222.

[25% and 50% compressive strength]

The 25% and 50% compressive strength of a foam sheet in the thickness direction were measured in accordance with JIS K6767-7.2.3 (JIS2009).

[Heat conductivity of foam sheet]

The heat conductivity of an unfoamed resin sheet was measured at 25°C by "TC-7000" manufactured by ULVAC-RIKO, Inc., in accordance with a laser flash method. Thereafter, heat conductivity was computationally obtained as a calculation value based on the following expression and an apparent density.

$$1/\lambda_e = \{(1\text{-}V^{1/3})/\lambda_S\} + V^{1/3}/\{\lambda_S\cdot(1\text{-}V^{2/3}) + \lambda_g\cdot V^{2/3}\}$$

$\lambda_e$ denotes the heat conductivity of foam sheet,
V denotes the porosity of foam sheet (porosity = 1-[1/expansion ratio]),
$\lambda_S$ denotes the heat conductivity of unfoamed resin sheet,
$\lambda_g$ denotes the heat conductivity of air

[Heat conductivity]

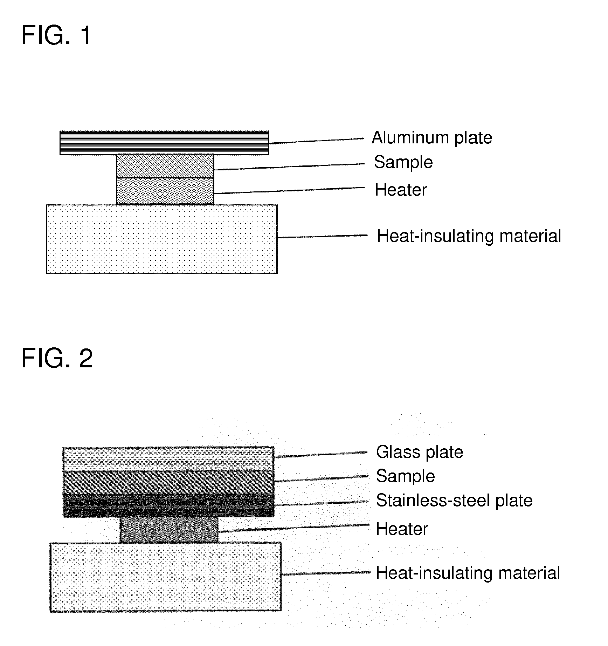

As shown in Fig. 1, a heater (microceramic heater, model number "MS5", manufactured by SAKAGUCHI E.H. VOC. CORP.) of 25 mm x 25 mm x 2 mm was put on a heat-insulating material. On the heater, a sample of 25 mm x 25 mm produced in each of Examples and Comparative Examples was laid. On the sample, an aluminum plate of 50 mm x 100 mm x 2 mm was put. In this manner, a structure for dispersing heat transmitted through the sample in the aluminum plate was formed. In this state, an electric power of 1 W was applied to the heater. In 15 minutes when the temperature of the heater reached a constant value, the temperature [T] (°C) of the heater was measured. It is shown that the heat conductivity is better as the value is smaller.

Table 1

| | | Example | | | | | | Comparative Example | | |
|---|---|---|---|---|---|---|---|---|---|---|
| | | 1 | 2 | 3 | 4 | 5 | 6 | 1 | 2 | 3 |
| Composition | Content of heat conductor [parts by mass]*1 | 400 | 400 | 400 | 400 | 360 | 360 | 0 | 400 | 400 |
| Physical property of foam sheet | Expansion ratio (times) | 2.25 | 2.1 | 3 | 2.21 | 2.14 | 3.5 | 8.33 | 2.22 | 1.14 |
| | Apparent density (g/cm$^3$) | 0.98 | 1 | 0.7 | 0.95 | 0.98 | 0.6 | 0.12 | 0.99 | 1.93 |
| | Thickness (mm) | 0.5 | 0.5 | 0.5 | 0.5 | 0.5 | 0.5 | 0.5 | 2 | 0.5 |
| | 25% Compression strength (kPa) | 130 | 85 | 35 | 152 | 125 | 26 | 33 | 135 | 985 |
| | 50% Compression strength (kPa) | 398 | 190 | 110 | 410 | 374 | 85 | 70 | 432 | Not measured |
| Evaluation | Heat conductivity (W/m.K) | 0.53 | 0.61 | 0.54 | 0.76 | 0.77 | 0.46 | 0.04 | 0.54 | 1.2 |
| | Temperature of heater [T] (°C) | 34 | 35 | 36 | 33 | 33 | 37 | 47 | 50 | 32 |
| *1 Content of heat conductor to 100 parts by mass of elastomer resin | | | | | | | | | | |

From the results of Examples and Comparative Examples, it is found that the heat conductive foam sheet (1) for electronic equipment of the present invention is thin and flexible as well as excellent in heat conductivity.

The materials used in the following Examples 7 to 10 and Comparative Examples 4 and 5 are as follows.

(1) Butyl rubber
Isobutylene-isoprene rubber manufactured by Exxon,
Trade name "Butyl 065"
Density: 0.92 g/cm$^3$
Mooney viscosity (100°C) = 47 (ML)
Unsaturation degree = 2.0
(2) Ethylene-propylene rubber
Model number "EP21", manufactured by JSR Corporation,
Mooney viscosity (125°C) = 26 (ML)
(3) Ethylene-propylene-diene rubber (EPDM)
Trade name "EP21", manufactured by JSR Corporation,
Density: 0.86 g/cm$^3$
Content of propylene: 34 mass%
(4) Liquid-state ethylene-propylene-diene rubber (liquid-state EPDM)
Trade name "PX-068", manufactured by Mitsui Chemicals, Inc.,
Density: 0.9 g/cm$^3$
Content of propylene: 39 mass%
(5) Azodicarbonamide
Trade name "SO-L", manufactured by Otsuka Chemical Co., Ltd.,
(6) Talc
Trade name "P-6", manufactured by Nippon Talc Co., Ltd.,
Average particle size: 4 μm
(7) Boron nitride
Trade name "Denka Boron Nitride SGP", manufactured by Denki Kagaku Kogyo K.K.
Average particle size: 15 μm
(8) Phenol oxidant
Trade name "IRGANOX1010", manufactured by Ciba Specialties Chemicals

<Examples 7 to 10 and Comparative Examples 4 and 5>

Example 7

100 parts by mass of a butyl rubber, 16 parts by mass of azodicarbonamide, 200 parts by mass of talc and 0.1 parts by mass of a phenol oxidant were melt-kneaded and then pressed to obtain an expandable resin sheet having a thickness of 0.4 mm.

To both surfaces of the obtained expandable resin sheet, 2.5 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.74 g/cm$^3$ and a thickness of 0.5 mm.

Example 8

100 parts by mass of a butyl rubber, 16 parts by mass of azodicarbonamide, 220 parts by mass of boron nitride and 0.1 parts by mass of a phenol oxidant were melt-kneaded and then pressed to obtain an expandable resin sheet having a thickness of 0.4 mm.

To both surfaces of the obtained expandable resin sheet, 2.5 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.76 g/cm$^3$ and a thickness of 0.5 mm.

Example 9

100 parts by mass of an ethylene-propylene rubber, 17.5 parts by mass of azodicarbonamide, 220 parts by mass of boron nitride and 0.1 parts by mass of a phenol oxidant were melt-kneaded and then pressed to obtain an expandable resin sheet having a thickness of 0.4 mm.

To both surfaces of the obtained expandable resin sheet, 2.5 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.74 g/cm$^3$ and a thickness of 0.5 mm.

Example 10

70 parts by mass of an ethylene-propylene-diene rubber, 30 parts by mass of a liquid-state ethylene-propylene-diene rubber, 17.5 parts by mass of azodicarbonamide, 220 parts by mass of boron nitride and 0.1 parts by mass of a phenol oxidant were melt-kneaded and then pressed to obtain an expandable resin sheet having a thickness of 0.38 mm.

To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.44 g/cm$^3$ and a thickness of 0.5 mm.

Comparative Example 4

A heat dissipation silicon pad ("TC-CAS-10" manufactured by Shin-Etsu Chemical Co., Ltd., thickness: 0.5 mm, heat conductivity: 1.8 W/m·K) was used as Comparative Example 4.

Comparative Example 5

100 parts by mass of an ethylene-propylene rubber, 220 parts by mass of boron nitride and 0.1 parts by mass of a phenol oxidant were melt-kneaded and then pressed to obtain a resin compound sheet having a thickness of 0.5 mm and an apparent density 1.5 g/cm$^3$.

<Physical properties>

Physical properties of the obtained foam sheets were measured as follows. The measurement results of individual properties are shown in Table 2.

[Expansion ratio]

The expansion ratio was calculated by dividing the specific gravity of a foam sheet by the specific gravity of an expandable sheet.

[Apparent density]

Apparent density was measured in accordance with JIS K 7222.

[25% compressive strength]

The 25% compressive strength of a foam sheet in the thickness direction was measured in accordance with JIS K6767-7.2.3 (JIS2009).

[Measurement dielectric constant]

The dielectric constant of a foam sheet was measured by an LCR meter in accordance with an automatic balancing bridge method, in the conditions of 1 MHz and a main electrode diameter of 28 $\phi$ (tin foil is added).

[Heat conductivity of foam sheet]

The heat conductivity was measured at 25°C by "TC-7000" manufactured by ULVAC-RIKO, Inc., in accordance with a laser flash method.

[Heat conductivity]

As shown in Fig. 1, a heater (microceramic heater, model number "MS5", manufactured by SAKAGUCHI E.H. VOC. CORP.) of 25 mm x 25 mm x 2 mm was put on a heat-insulating material. On the heater, a sample of 25 mm x 25 mm was laid. On the sample, an aluminum plate of 50 mm x 100 mm x 2 mm was put. In this manner, a structure for dispersing heat transmitted through the sample in the aluminum plate was formed. In this state, an electric power of 1 W was applied to the heater. In 15 minutes when the temperature of the heater reached a constant value, the temperature [T] (°C) of the heater was measured. It is shown that the heat conductivity is better as the value is smaller.

Table 2

| | | Example | | | | Comparative Example | |
|---|---|---|---|---|---|---|---|
| | | 7 | 8 | 9 | 10 | 4 | 5 |
| Composition | Content of heat conductor [parts by mass]*1 | 200 | 220 | 220 | 220 | 0 | 220 |
| Physical property of foam sheet | Expansion ratio (times) | 2.03 | 2.11 | 1.96 | 3.50 | 1.00 | 1.00 |
| | Apparent density (g/cm$^3$) | 0.74 | 0.76 | 0.74 | 0.44 | 1.90 | 1.50 |
| | Thickness (mm) | 0.5 | 0.5 | 0.5 | 0.5 | 0.5 | 0.5 |
| | 25% Compression strength (kPa) | 78 | 93 | 115 | 33 | 50 | 780 |
| Evaluation | Specific dielectric constant | 1.50 | 1.74 | 1.83 | 1.43 | 4.80 | 4.20 |
| | Heat conductivity (W/m·K) | 0.4 | 0.5 | 0.85 | 0.55 | 1.8 | 1.4 |
| | Temperature of heater [T] (°C) | 39 | 36 | 35 | 36 | 33 | 33 |

*1: Content of heat conductor to 100 parts by mass of elastomer resin

From the results of Examples and Comparative Examples, it is found that the heat conductive foam sheet (1) for electronic equipment of the present invention is low in specific dielectric constant, and thin and flexible; at the same time, it has the same heat conductivity as in the silicone sheet.

[Heat conductive foam sheet (2) for electronic equipment of the present invention]

The materials used in the following Examples and Comparative Examples regarding the heat conductive foam sheet (2) for electronic equipment of the present invention are as follows.

(1) Acrylonitrile butadiene rubber (NBR)
Trade name "Nipol 1041", manufactured by ZEON CORPORATION
Density: 1.00 g/cm$^3$
Acrylonitrile component: 40.5 mass%
(2) Ethylene-propylene-diene rubber (EPDM)
Trade name "EP21", manufactured by JSR Corporation,
Density: 0.86 g/cm$^3$
Content of propylene: 34 mass%
(3) Liquid ethylene-propylene-diene rubber (liquid-state EPDM)
Trade name "PX-068", manufactured by Mitsui Chemicals, Inc.
Density: 0.9 g/cm$^3$
Content of propylene: 39 mass%
(4) Azodicarbonamide
Trade name "SO-L", manufactured by Otsuka Chemical Co., Ltd.
(5) Graphite
Trade name "XGnP-H-5", manufactured by XG Sciences,
Shape: scale-like
Major axis: 5 μm in average
Minor axis: 5 μm in average
Thickness: 15 nm in average
Major axis/thickness = 5/0.015 = 333.3
(6) Boron nitride
Trade name "Denka boron nitride SGP", manufactured by Denki Kagaku Kogyo K.K.,
Shape: Scale-like

Major axis: 15 μm in average
Minor axis: 15 μm in average
Thickness: 3 μm in average
Major axis/thickness = 15/3 = 5
(7) Magnesium oxide
Trade name "RF-10C-SC", manufactured by Ube Material Industries,
Shape: Round pulverized product
Average particle size: 4 μm
(8) Aluminum oxide
Spherical alumina, trade name "AX3-32", manufactured by Micron Inc.
Shape: Spherical
Average particle size: 3 μm
(9) Phenol oxidant
Trade name "IRGANOX1010", manufactured by Ciba Specialties Chemicals

<Examples 11 to 14 and Comparative Examples 6 to 10>

Example 11

100 parts by mass of an acrylonitrile butadiene rubber, 15 parts by mass of azodicarbonamide, 220 parts by mass of graphite and 0.1 parts by mass of a phenol oxidant were melt-kneaded and then pressed to obtain an expandable resin sheet having a thickness of 0.4 mm.

To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.79 g/cm$^3$ and a thickness of 0.5 mm.

Example 12

100 parts by mass of an acrylonitrile butadiene rubber, 16 parts by mass of azodicarbonamide, 220 parts by mass of boron nitride and 0.1 parts by mass of a phenol oxidant were melt-kneaded and then pressed to obtain an expandable resin sheet having a thickness of 0.4 mm.

To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.76 g/cm$^3$ and a thickness of 0.5 mm.

Example 13

70 parts by mass of an ethylene-propylene-diene rubber, 30 parts by mass of a liquid-state ethylene-propylene-diene rubber, 15 parts by mass of azodicarbonamide, 220 parts by mass of graphite and 0.1 parts by mass of a phenol oxidant were melt-kneaded and then pressed to obtain an expandable resin sheet having a thickness of 0.4 mm.

To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.44 g/cm$^3$ and a thickness of 0.5 mm.

Example 14

70 parts by mass of an ethylene-propylene-diene rubber, 30 parts by mass of a liquid-state ethylene-propylene-diene rubber, 16 parts by mass of azodicarbonamide, 220 parts by mass of boron nitride and 0.1 parts by mass of a phenol oxidant were melt-kneaded and then pressed to obtain an expandable resin sheet having a thickness of 0.4 mm.

To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.42 g/cm$^3$ and a thickness of 0.5 mm.

Comparative Example 6

100 parts by mass of an acrylonitrile butadiene rubber, 15 parts by mass of azodicarbonamide, 360 parts by mass of magnesium oxide and 0.1 parts by mass of a phenol oxidant were supplied to an extruder, melt-kneaded and then pressed to obtain an expandable resin sheet having a thickness of 0.4 mm

To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 1.03 g/cm$^3$ and a thickness of 0.5 mm.

Comparative Example 7

100 parts by mass of an acrylonitrile butadiene rubber, 15 parts by mass of azodicarbonamide, 400 parts by mass of aluminum oxide and 0.1 parts by mass of a phenol oxidant were melt-kneaded and then pressed to obtain an expandable resin sheet having a thickness of 0.4 mm.

To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.98 g/cm$^3$ and a thickness of 0.5 mm.

Comparative Example 8

60 parts by mass of an ethylene-propylene-diene rubber, 40 parts by mass of a liquid-state ethylene-propylene-diene rubber, 15 parts by mass of azodicarbonamide, 360 parts by mass of magnesium oxide and 0.1 parts by mass of a phenol oxidant were melt-kneaded and then pressed to obtain an expandable resin sheet having a thickness of 0.4 mm.

To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.70 g/cm$^3$ and a thickness of 0.5 mm.

Comparative Example 9

100 parts by mass of an acrylonitrile butadiene rubber, 8 parts by mass of azodicarbonamide, 400 parts by mass of aluminum oxide and 0.1 parts by mass of a phenol oxidant were melt-kneaded and then pressed to obtain an expandable resin sheet having a thickness of 0.48 mm.

To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 1.93 g/cm$^3$ and a thickness of 0.5 mm.

Comparative Example 10

100 parts by mass of an acrylonitrile butadiene rubber, 6 parts by mass of azodicarbonamide and 0.1 parts by mass of a phenol oxidant were supplied to an extruder, melt-kneaded and then pressed to obtain an expandable resin sheet having a thickness of 0.25 mm.

To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.12 g/cm$^3$ and a thickness of 0.5 mm.

<Physical properties>

Physical properties of the obtained foam sheets were measured as follows. The measurement results of individual properties are shown in Table 3.

[25% compressive strength]

The 25% compressive strengths, i.e., strength during application of 25% compressive strain, of the obtained sheets in the thickness direction were measured in accordance with JIS K6767-7.2.3 (JIS2009).

[Expansion ratio]

The expansion ratio was calculated by dividing the specific gravity of a foam sheet by the specific gravity of an expandable sheet.

[Heat conductivity of foam sheet]

The heat conductivity was measured at 25°C by "TC-7000" manufactured by ULVAC-RIKO, Inc., in accordance with a laser flash method.

[Apparent density]

Apparent density was measured in accordance with JIS K 7222.

[Heat conductivity]

As shown in Fig. 2, a heater (microceramic heater, model number "MS5", manufactured by SAKAGUCHI E.H. VOC. CORP.) of 25 mm x 25 mm x 2 mm was put on a heat-insulating material. On the heater, a stainless steel plate (SUS304) of 60 mm x 100 mm x 0.6 mm was laid. Further on the stainless steel plate, a sample of 60 mm x 100 mm formed in each of Examples and Comparative Examples and a glass plate of 60 mm x 100 mm x 0.5 mm were laid in this order. In this state, an electric power of 2.6 W (enough to increase temperature up to 90°C by the heater alone) was applied to the heater. In 15 minutes when the temperature of the heater reached a constant value, the temperature [T] (°C) of the heater was measured. It is shown that the heat conductivity is better as the value is smaller.

Table 3

| | | Example | | | | Comparative Example | | | | |
|---|---|---|---|---|---|---|---|---|---|---|
| | | 11 | 12 | 13 | 14 | 6 | 7 | 8 | 9 | 10 |
| Composition | Content of heat conductor [parts by mass]*1 | 220 | 220 | 220 | 220 | 360 | 400 | 360 | 400 | 0 |
| Physical property of foam sheet | Expansion ratio (times) | 2.03 | 2.24 | 3.5 | 4 | 2.25 | 2.25 | 3 | 1.14 | 8.83 |
| | Apparent density (g/cm$^3$) | 0.79 | 0.76 | 0.44 | 0.42 | 1.03 | 0.98 | 0.7 | 1.93 | 0.12 |
| | Thickness (mm) | 0.5 | 0.5 | 0.5 | 0.5 | 0.5 | 0.5 | 0.5 | 0.5 | 0.5 |
| | 25% Compression strength (kPa) | 140 | 119 | 50 | 43 | 108 | 130 | 80 | 985 | 33 |
| Evaluation | Heat conductivity (W/m·K) | 1.2 | 0.55 | 0.8 | 0.3 | 0.6 | 0.5 | 0.4 | 1.2 | 0.04 |
| | Temperature of heater [T] (°C) | 54 | 56 | 54 | 57 | 60 | 60 | 65 | 54 | 86 |
| *1: Content of heat conductor to 100 parts by mass of elastomer resin | | | | | | | | | | |

From the results of Examples and Comparative Examples, it is found that the heat conductive foam sheet (2) for electronic equipment of the present invention is thin and flexible as well as excellent in heat conductivity.

[Heat conductive laminate for electronic equipment of the present invention]

The materials used in the following Examples and Comparative Examples regarding heat conductive laminate for electronic equipment of the present invention are as follows.

(1) Linear low-density polyethylene
Trade name "KERNEL KF370", manufactured by Japan Polyethylene Corporation,

Density: 1.00 g/cm$^3$
(2) Acrylonitrile butadiene rubber (NBR)
Trade name "Nipol 1041", manufactured by ZEON CORPORATION
Density: 1.00 g/cm$^3$
Acrylonitrile component: 40.5 mass%
(3) Ethylene-propylene-diene rubber (EPDM)
Trade name "EP21", manufactured by JSR Corporation,
Density: 0.86 g/cm$^3$
Content of propylene: 34 mass%
(4) Liquid ethylene-propylene-diene rubber (liquid-state EPDM)
Trade name "PX-068", manufactured by Mitsui Chemicals, Inc.
Density: 0.9 g/cm$^3$
Content of propylene: 39 mass%
(5) Azodicarbonamide
Trade name "SO-L", manufactured by Otsuka Chemical Co., Ltd.
(6) Aluminum oxide
Trade name "AX3-32", spherical alumina, manufactured by Micron Inc.,
Average particle size: 3 μm
(7) Magnesium oxide
Trade name "RF-10C-SC", manufactured by Ube Material Industries, Round pulverized product
Average particle size: 4 μm
(8) Phenol oxidant
Trade name "IRGANOX1010", manufactured by Ciba Specialties Chemicals

<Examples 15 to 18 and Comparative Examples 11 to 14>

Example 15

100 parts by mass of a linear low-density polyethylene obtained by using a metallocene compound as a polymerization catalyst, 3.0 parts by mass of azodicarbonamide and 0.1 parts by mass of a phenol oxidant were melt-kneaded and then pressed to obtain an expandable resin sheet having a thickness of 0.36 mm.
To both surfaces of the obtained expandable resin sheet, 4 Mrad of an electron beam was applied at an acceleration voltage of 500 kV to crosslink the expandable resin sheet. Subsequently, the sheet was heated to 250°C to expand the expandable resin sheet to obtain a foam sheet having an apparent density of 0.20 g/cm$^3$ and a thickness of 0.5 mm.
To one of the surfaces of the foam sheet obtained, a copper-foil tape (No: 2194 manufactured by 3M) of 150 μm in thickness was bonded to obtain a laminate of the foam sheet and the copper foil.

Example 16

100 parts by mass of an acrylonitrile butadiene rubber, 15 parts by mass of azodicarbonamide, 400 parts by mass of aluminum oxide and 0.1 parts by mass of a phenol oxidant were melt-kneaded and then pressed to obtain an expandable resin sheet having a thickness of 0.4 mm.
To both surfaces of the obtained expandable resin sheet, 1.2 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.98 g/cm$^3$ and a thickness of 0.5 mm.
To one of the surfaces of the foam sheet obtained, a copper-foil tape (No: 2194 manufactured by 3M) of 150 μm in thickness was bonded to obtain a laminate of the foam sheet and the copper foil.

Example 17

70 parts by mass of an ethylene-propylene-diene rubber, 30 parts by mass of a liquid-state ethylene-propylene-diene rubber, 17.5 parts by mass of azodicarbonamide, 400 parts by mass of aluminum oxide and 0.1 parts by mass of a phenol oxidant were melt-kneaded and then pressed to obtain an expandable resin sheet having a thickness of 0.4 mm.
To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.47 g/cm$^3$ and a thickness

of 0.5 mm.

To one of the surfaces of the foam sheet obtained, a copper-foil tape (No: 2194 manufactured by 3M) of 150 μm in thickness was bonded to obtain a laminate of the foam sheet and the copper foil.

Example 18

60 parts by mass of an ethylene-propylene-diene rubber, 40 parts by mass of a liquid-state ethylene-propylene-diene rubber, 17 parts by mass of azodicarbonamide, 360 parts by mass of magnesium oxide and 0.1 parts by mass of a phenol oxidant were melt-kneaded and then pressed to obtain an expandable resin sheet having a thickness of 0.4 mm.

To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.60 g/cm$^3$ and a thickness of 0.5 mm.

To one of the surfaces of the foam sheet obtained, a copper-foil tape (No: 2194 manufactured by 3M) of 150 μm in thickness was bonded to obtain a laminate of the foam sheet and the copper foil.

Comparative Example 11

A foam sheet was obtained in the same manner as in Example 15 except that a copper foil was not bonded.

Comparative Example 12.

A foam sheet was obtained in the same manner as in Example 16 except that a copper foil was not bonded.

Comparative Example 13

A foam sheet was obtained in the same manner as in Example 17 except that a copper foil was not bonded and the expansion ratio was changed as described in Table 4.

Comparative Example 14

A foam sheet was obtained in the same manner as in Example 18 except that that a copper foil was not bonded.

<Physical properties>

Physical properties of the obtained foam sheets were measured as follows. The measurement results of individual properties are shown in Table 4.

[25% compressive strength]

The 25% compressive strength of a foam sheet in the thickness direction was measured in accordance with JIS K6767-7.2.3 (JIS2009)

[Expansion ratio]

The expansion ratio was calculated by dividing the specific gravity of a foam sheet by the specific gravity of an expandable sheet.

[Heat conductivity of the foam sheet]

The heat conductivity was measured at 25°C by "TC-7000" manufactured by ULVAC-RIKO, Inc. in accordance with a laser flash method.

[Apparent density]

Apparent density was measured in accordance with JIS K 7222.

[Heat conductivity]

As shown in Fig. 2, a heater (microceramic heater, model number "MS5", manufactured by SAKAGUCHI E.H. VOC. CORP.) of 25 mm x 25 mm x 2 mm was put on a heat-insulating material. On the heater, a stainless steel plate (SUS304) of 60 mm x 100 mm x 0.6 mm was laid. Further on the stainless steel plate, a sample of 60 mm x 100 mm formed in each of Examples and Comparative Examples and a glass plate of 60 mm x 100 mm x 0.5 mm were laid in this order. In this state, an electric power of 2.6 W (enough to increase temperature up to 90°C by the heater alone) was applied to the heater. In 15 minutes when the temperature of the heater reached a constant value, the temperature [T] (°C) of the heater was measured. It is shown that the heat conductivity is better as the value is smaller.

Table 4

| | | Example | | | | Comparative Example | | | |
|---|---|---|---|---|---|---|---|---|---|
| | | 15 | 16 | 17 | 18 | 11 | 12 | 13 | 14 |
| Composition | Content of heat conductor [parts by mass]*1 | 0 | 400 | 400 | 360 | 0 | 400 | 400 | 360 |
| Physical property of foam sheet | Expansion ratio (times) | 5.00 | 2.25 | 4.50 | 3.50 | 5.00 | 2.25 | 4.00 | 3.50 |
| | Apparent density (g/cm$^3$) | 0.20 | 0.98 | 0.47 | 0.60 | 0.20 | 0.98 | 0.53 | 0.60 |
| | Thickness (mm) | 0.5 | 0.5 | 0.5 | 0.5 | 0.5 | 0.5 | 0.5 | 0.5 |
| | 25% Compression strength (kPa) | 55 | 130 | 30 | 28 | 55 | 130 | 60 | 28 |
| | Heat conductivity (W/k·m) | 0.06 | 0.54 | 0.25 | 0.46 | 0.06 | 0.54 | 0.33 | 0.46 |
| Heat conductive sheet | Thickness (μm) | 150 | 150 | 150 | 150 | - | - | - | - |
| | Heat conductivity (W/k·m) | 398 | 398 | 398 | 398 | - | - | - | - |
| Thickness of laminate (mm) | | 0.65 | 0.65 | 0.65 | 0.65 | 0.50 | 0.50 | 0.50 | 0.50 |
| Evaluation | Temperature of heater [T] (°C) | 53 | 52 | 54 | 52 | 61 | 60 | 62 | 59 |
| *1: Content of heat conductor to 100 parts by mass of elastomer resin | | | | | | | | | |

From the results of Examples and Comparative Examples, it is found that the heat conductive laminate for electronic equipment of the present invention is thin and flexible as well as excellent in heat conductivity.

## Claims

1. A heat conductive foam sheet for electronic equipment containing a heat conductor in an elastomer resin portion constituting the foam sheet, wherein the content of the heat conductor relative to 100 parts by mass of the elastomer resin is 100 to 500 parts by mass, the 25% compressive strength of the foam sheet is 200 kPa or less and the thickness thereof is 0.05 to 1 mm.

2. The heat conductive foam sheet for electronic equipment according to Claim 1, wherein the heat conductor is at least one selected from the group consisting of aluminum oxide, magnesium oxide, boron nitride, talc, aluminum nitride, graphite and graphene.

3. The heat conductive foam sheet for electronic equipment according to Claim 1 or 2, wherein the heat conductivity of the foam sheet is 0.3 to 10 W/m·K.

4. The heat conductive foam sheet for electronic equipment according to any one of Claims 1 to 3, wherein the expansion ratio of the foam sheet is 1.5 to 5.

5. The heat conductive foam sheet for electronic equipment according to any one of Claims 1 to 4, wherein the elastomer resin is an acrylonitrile butadiene rubber or a liquid-state acrylonitrile butadiene rubber, and an ethylene-propylene-diene rubber or a liquid-state ethylene-propylene-diene rubber and a mixture thereof.

6. The heat conductive foam sheet for electronic equipment according to any one of Claims 1 to 5, wherein the elastomer resin contains a liquid elastomer in an amount of 10 mass% or more, and the 50% compressive strength of the foam sheet is 200 kPa or less.

7. The heat conductive foam sheet for electronic equipment according to any one of Claims 1 to 4, wherein the elastomer resin is a butyl rubber or an ethylene-propylene rubber.

8. The heat conductive foam sheet for electronic equipment according to any one of Claims 1 to 7, wherein a dielectric constant of the foam sheet is 4 or less.

9. A heat conductive foam sheet for electronic equipment containing a heat conductor in an elastomer resin portion constituting the foam sheet, wherein the heat conductor has a scale-like shape defined by a major axis of 1 to 300 μm, a minor axis of 1 to 300 μm and a ratio of the major axis to thickness (major axis/thickness) of 2 to 500 and/or a fibrous shape defined by a diameter of 0.01 to 50 μm and a ratio of length to the diameter (length/diameter) of 5 to 30,000; and the 25% compressive strength of the foam sheet is 200 kPa or less and the thickness thereof is 0.05 to 1 mm.

10. The heat conductive foam sheet for electronic equipment according to Claim 9, wherein the heat conductor is at least one selected from the group consisting of boron nitride, talc, aluminum nitride, graphite, a carbon nanotube and a carbon fiber

11. The heat conductive foam sheet for electronic equipment according to Claim 9 or 10, wherein the heat conductivity of the foam sheet is 0.3 to 10 W/m·K.

12. The heat conductive foam sheet for electronic equipment according to any one of Claims 9 to 11, wherein the expansion ratio of the foam sheet is 1.5 to 5.

13. The heat conductive foam sheet for electronic equipment according to any one of Claims 9 to 12, wherein the elastomer resin is an acrylonitrile butadiene rubber.

14. The heat conductive foam sheet for electronic equipment according to any one of Claims 9 to 13, wherein the content of the heat conductor relative to 100 parts by mass of the elastomer resin is 100 to 500 parts by mass.

15. A heat conductive laminate for electronic equipment, which has a heat conductive sheet having a heat conductivity of 200 W/m·K or more on at least one of the surfaces of a foam sheet having a 25% compressive strength of 200 kPa or less and a thickness of 0.05 to 1.0 mm; and which has a thickness of 0.08 to 1.50 mm.

16. The heat conductive laminate for electronic equipment according to Claim 15, wherein the elastomer resin constituting the foam sheet contains at least one heat conductive filler selected from the group consisting of aluminum oxide, magnesium oxide, boron nitride, talc and aluminum nitride.

17. The heat conductive laminate for electronic equipment according to Claim 16, wherein the content of the heat conductive filler relative to 100 parts by mass of the elastomer resin is 100 to 500 parts by mass.

18. The heat conductive laminate for electronic equipment according to any one of Claims 15 to 17, wherein the expansion ratio of the foam sheet is 1.5 to 6.

19. The heat conductive laminate for electronic equipment according to any one of Claims 15 to 18, wherein the heat conductive sheet is a sheet of one selected from copper, aluminum and graphite.

20. The heat conductive laminate for electronic equipment according to any one of Claims 15 to 19, wherein the elastomer resin constituting the foam sheet is an acrylonitrile butadiene rubber or a linear low-density polyethylene.

FIG. 1

Aluminum plate
Sample
Heater
Heat-insulating material

FIG. 2

Glass plate
Sample
Stainless-steel plate
Heater
Heat-insulating material

## INTERNATIONAL SEARCH REPORT

International application No. PCT/JP2013/071287

A. CLASSIFICATION OF SUBJECT MATTER
*C08J9/04*(2006.01)i, *C08K3/00*(2006.01)i, *C08L101/00*(2006.01)i

According to International Patent Classification (IPC) or to both national classification and IPC

B. FIELDS SEARCHED

Minimum documentation searched (classification system followed by classification symbols)
C08J9/00-9/42, C08K3/00, C08L101/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2002-128931 A (Sekisui Chemical Co., Ltd.), 09 May 2002 (09.05.2002), claims; paragraphs [0010], [0027], [0029], [0039]; examples; paragraph [0059] (Family: none) | 1-20 |
| Y | JP 2009-258274 A (Sekisui Chemical Co., Ltd.), 05 November 2009 (05.11.2009), claims; paragraphs [0013], [0031], [0049]; examples (Family: none) | 1-20 |
| Y | JP 2006-213845 A (Nippon Zeon Co., Ltd.), 17 August 2006 (17.08.2006), claims; paragraph [0033] (Family: none) | 9-14 |

[X] Further documents are listed in the continuation of Box C. [ ] See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| 30 October, 2013 (30.10.13) | 12 November, 2013 (12.11.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

INTERNATIONAL SEARCH REPORT

International application No. PCT/JP2013/071287

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-077872 A (Nitto Denko Corp.), 14 March 2000 (14.03.2000), claims; paragraphs [0013] to [0017]; examples (Family: none) | 15-20 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003031980 A

**Non-patent literature cited in the description**

- Plastic Foam Handbook. NIKKAN KOGYO SHIMBUN, LTD, 1973